# EUROPEAN PATENT APPLICATION

(11) **EP 4 776 096 A1**
(43) Date of publication of application: **15.07.2026**
(21) Application number: 25227557.3
(22) Date of filing: 30.12.2025
(51) Int. Cl.: G05F 1/575, H03F 3/189

(54) **MERGE AMPLIFIER AND REGULATOR WITH INTERNAL SENSING**

(30) Priority: 14.01.2025 US 202563744899 P; 10.12.2025 US 202519415755
(71) Applicant: MediaTek Inc., Hsinchu City 30078 (TW)
(72) Inventor: SHABRA, Ayman, San Jose, 95134 (US); WU, Jonathan Xiang, San Jose, 95134 (US); SHIH, Yu-Chuan, San Jose, 95134 (US)
(74) Representative: Hoefer & Partner Patentanwälte mbB

(57) **Abstract**

The present invention provides a circuitry (100) including a regulator (110), a load circuit (120) and a signal processing circuit (130). The regulator (110) is configured to receive a supply voltage to generate a regulated supply voltage according to a reference voltage and a feedback signal. The load circuit (120) is supplied by the regulated supply voltage, wherein the load circuit (120) includes an internal sensing circuit to generate an internal sensing signal. The signal processing circuit (130) is configured to process the internal sensing signal to generate the feedback signal to the regulator.

## Description

### Field of the Invention

The present invention relates to a circuitry comprising a regulator and a load circuit.

### Background of the Invention

Traditional power supply designs often use a Low-Dropout (LDO) linear regulator to power a load circuit, such as an amplifier. Conventionally, the LDO is implemented as a fully self-contained and separate unit from the load circuit. This means the LDO and the load circuit are designed and treated as distinct, independent blocks.

In this conventional approach, the LDO's feedback mechanism is based on the supply voltage provided to the load. In some instances, this voltage may undergo a level-shifting operation before being fed back to the LDO. This method of using a separate LDO to power a load circuit is widely practiced, even in cases where the LDO is dedicated to supplying power to a single, specific load, like an amplifier. The primary advantage of this separate design strategy lies in the "divide-and-conquer" approach it allows. Designers can effectively simplify the overall design process by treating the complex LDO design and the load circuit design as independent tasks.

However, the aforementioned conventional method faces specific technical challenges when applied to wide bandwidth amplifier circuits, particularly those requiring on-chip integration. Specifically, wide bandwidth amplifiers must support low-frequency bands. This requirement necessitates a large value for the RF (radio frequency) choke used in the power delivery path, typically around 10 nH. In applications with a narrow frequency band, such a large choke can be placed external to the chip, within the package, or on the printed circuit board (PCB). However, in wide bandwidth applications, using a large external or in-package choke significantly degrades the wideband frequency response. Consequently, these RF chokes must be integrated directly on-chip. This on-chip integration, while necessary for wide bandwidth performance, introduces several issues, such as voltage drop and operating point drift due to the on-chip RF choke.

In addition, since the resistance of the on-chip RF choke varies with semiconductor process variations, the resulting voltage drop and operating point drift caused by the on-chip RF choke will have a corresponding variable impact on the load circuit (e.g., an amplifier). This variability may ultimately affect the operation or performance of the load circuit.

### Summary of the Invention

Therefore, it is an object of the present invention to provide an integrated design where the LDO and the load circuit are implemented on a single chip, to solve the above-mentioned problems.

According to one embodiment of the present invention, a circuitry comprising a regulator, a load circuit and a signal processing circuit is disclosed. The regulator is configured to receive a supply voltage to generate a regulated supply voltage according to a reference voltage and a feedback signal. The load circuit is supplied by the regulated supply voltage, wherein the load circuit comprises an internal sensing circuit to generate an internal sensing signal. The signal processing circuit is configured to process the internal sensing signal to generate the feedback signal to the regulator.

### Brief Description of the Drawings

FIG. 1 is a diagram illustrating a circuitry according to one embodiment of the present invention.
FIG. 2 is a diagram illustrating a circuitry according to one embodiment of the present invention.
FIG. 3 is a diagram illustrating a circuitry according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

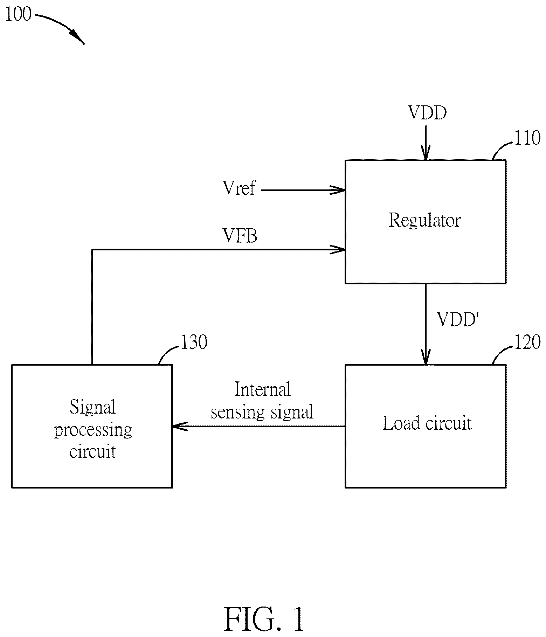

FIG. 1 is a diagram illustrating a circuitry 100 according to one embodiment of the present invention. As shown in FIG. 1, the circuitry 100 comprises a regulator 110, a load circuit 120 and a signal processing circuit 130. In this embodiment, the regulator 110, the load circuit 120 and the signal processing circuit 130 are within a chip.

The regulator 110 can be an LDO regulator, a linear regulator or any regulator configured to suppress the noise of a supply voltage VDD to generate a regulated supply voltage VDD', wherein the regulated supply voltage VDD' can be regarded as a stable supply voltage. In one embodiment, the regulator 110 generates the regulated supply voltage VDD' according to a reference voltage Vref and a feedback signal VFB. For example, the regulator 110 may use a comparator to compare the reference voltage Vref and the feedback signal to generate a comparison result, and use the comparison result to control a switch to selectively connect the supply voltage VDD to an output terminal of the regulator 110, to generate the regulated supply voltage VDD'. It is noted that the above operation of regulator 110 is for illustration purposes and is not a limitation of the present invention. In addition, because the main components within the regulator 110 are known by a person skilled in the art, detailed descriptions of the regulator 110 are omitted here.

The load circuit 120 is supplied by the regulated supply voltage, wherein the load circuit 120 can be an amplifier, a RF circuit, an analog and mixed-signal circuit, or any other circuit that required a stable supply voltage. The load circuit 120 further provides an internal sensing signal, wherein the internal sensing signal can be a voltage signal or a current signal that is generated from an internal node whose current/voltage may influence the performance of the load circuit. For example, the internal sensing signal may be a common-mode voltage of an amplifier, or a voltage at a specific node, such as an output node, of the load circuit 120.

The signal processing circuit 130 is used to process the internal sensing signal to generate the feedback signal VFB to the regulator 110. The signal processing circuit 130 may be a level shifter or any other suitable circuit which can adjust or convert the internal sensing signal of the load circuit 120 to generate the feedback signal VFB, in order for the regulator 110 to adjust the voltage level of the regulated supply voltage VDD'.

In the embodiment shown in FIG. 1, by using the internal sensing signal of the load circuit 120 to generate the feedback signal VFB, for the regulator 110 to adjust the voltage level of the regulated supply voltage VDD', the load circuit 120 can maintain good performance even in the presence of semiconductor process variation (or process corner variations).

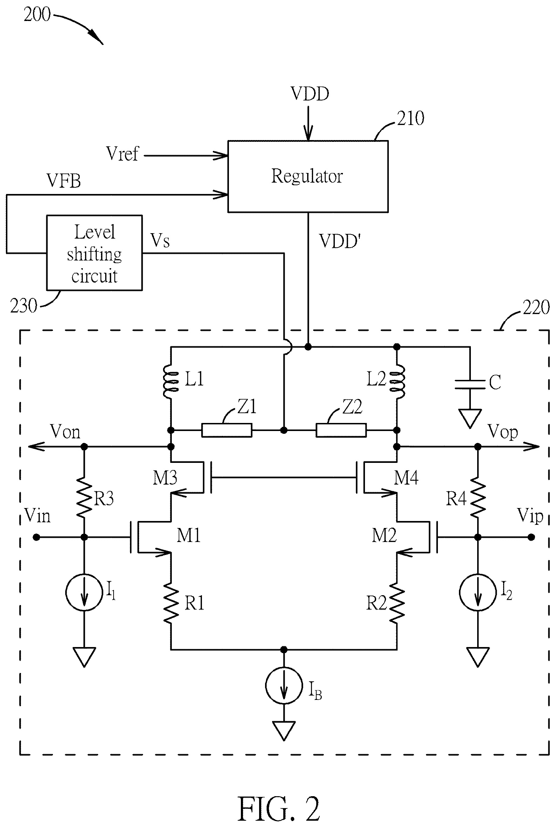

FIG. 2 is a diagram illustrating a circuitry 200 according to one embodiment of the present invention. As shown in FIG. 2, the circuitry 200 comprises a regulator 210, an amplifier 220 and a level shifter 230. In this embodiment, the regulator 210, the amplifier 220 and the level shifting circuit 230 are within a chip.

The regulator 210 can be a LDO regulator, a linear regulator or any regulator which can suppress the noise of a supply voltage VDD to generate a regulated supply voltage VDD', wherein the regulated supply voltage VDD' can be regarded as a stable supply voltage. In one embodiment, the regulator 210 generates the regulated supply voltage VDD' according to a reference voltage Vref and a feedback signal VFB.

The amplifier 220 is supplied by the regulated supply voltage VDD', and configured to receive a differential input signal Vin, Vip to generate a differential output signal Von, Vop. The amplifier 220 comprises transistors M1 - M4, resistors R1 - R4, current sources I1, I2 and IB, devices such as RF chokes L1 and L2, and an internal sensing circuit comprising two impedance circuit Z1 and Z2, and a decoupling capacitor C. The transistors M1 - M2 are implemented by N-type transistors. A gate electrode of the transistor M1 receives the input signal Vin, a source electrode of the transistor M1 is coupled to a ground voltage via the resistor R1 and the current source IB, and a drain electrode of the transistor M1 is coupled to a source electrode of the transistor M3. A gate electrode of the transistor M2 receives the input signal Vip, a source electrode of the transistor M2 is coupled to the ground voltage via the resistor R1 and the current source IB, and a drain electrode of the transistor M2 is coupled to a source electrode of the transistor M4. A gate electrode of the transistor M3 is coupled to a gate electrode of the transistor M4 and then coupled to a bias circuit which is not shown in FIG. 2 for simplicity of illustration. The drain electrodes of the transistors M3 and M4 are coupled to the regulated supply voltage VDD' via the RF chokes, wherein the drain electrodes of the transistors M3 and M4 serve as output terminals of the amplifier 220 for outputting the differential output signal Von, Vop. The resistor R3 and current source I1 are coupled to the input signal Vin and output signal Von, and the resistor R4 and current source I2 are coupled to the input signal Vip and output signal Vop. The impedance circuits Z1 and Z2 are coupled between the drain electrodes of the transistors M3 and M4. The decoupling capacitor C is coupled to the regulated supply voltage VDD'.

For high performance applications, the signal distortion of the amplifier 220 is sensitive to the drain voltages of the transistors M3 and M4, or sensitive to the terminals of the RF chokes. Therefore, the internal sensing circuit uses the impedance circuits Z1 and Z2 to sense the common-mode voltage of the output terminals of the amplifier 220 (i.e., drain electrodes of the transistors M3 and M4), as the internal sensing signal Vs.

It is noted that the detailed circuit structure of the amplifier 220 shown in FIG. 2 is for illustration, not a limitation of the present invention. In other embodiments, the transistors M1 - M4 may be implemented by P-type transistors, the quantity of the transistors can be adjusted according to a designer's consideration, resistors R3 and R4 may be removed, other elements may be added into the amplifier 220, the transistors M1 - M4 may be replaced by any other suitable amplification circuit, or a single-ended amplifier may be designed.

In addition, the internal sensing circuit comprising the impedance circuits Z1 and Z2 is for illustrative, not a limitation of the present invention. As long as an internal sensing signal, which may influence the performance of the amplifier 220, can be obtained, the internal sensing circuit may have different circuit design. For example, if the amplifier 220 has a single-ended design, the internal sensing circuit may directly sense the voltage at an output terminal of the amplifier, as the internal sensing signal Vs.

The level shifting circuit 230 is configured to adjust a voltage level of the internal sensing signal Vs to generate the feedback signal VFB, for the regulator 210 to adjust the voltage level of the regulated supply voltage VDD'.

In the embodiment shown in FIG. 2, by using the internal sensing signal Vs of the amplifier 220 to generate the feedback signal VFB, for the regulator 210 to adjust the voltage level of the regulated supply voltage VDD', the amplifier 220 can maintain good performance even in the presence of semiconductor process variation (or process corner variations).

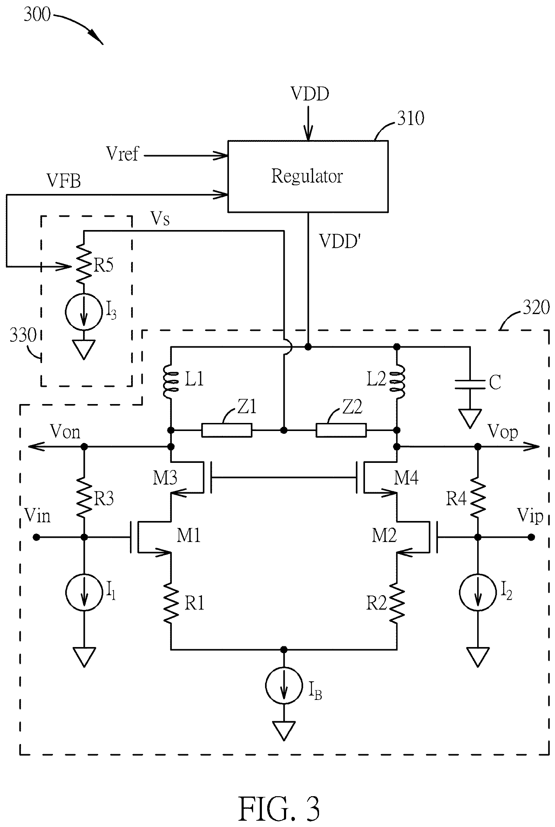

FIG. 3 is a diagram illustrating a circuitry 300 according to one embodiment of the present invention. As shown in FIG. 3, the circuitry 300 comprises a regulator 310, an amplifier 320 and a signal processing circuit 330. In this embodiment, the regulator 310, the amplifier 320 and the signal processing circuit 330 are within a chip.

The regulator 310 can be a LDO regulator, a linear regulator or any regulator which can suppress the noise of a supply voltage VDD to generate a regulated supply voltage VDD', wherein the regulated supply voltage VDD' can be regarded as a stable supply voltage. In one embodiment, the regulator 310 generates the regulated supply voltage VDD' according to a reference voltage Vref and a feedback signal VFB.

The amplifier 320 is supplied by the regulated supply voltage VDD', and configured to receive a differential input signal Vin, Vip to generate a differential output signal Von, Vop. The circuit structure of amplifier 320 is the same as the amplifier 220 shown in FIG. 2, so detailed descriptions of the amplifier 320 are omitted here.

The signal processing circuit 330 is configured to process the internal sensing signal to generate the feedback signal VFB to the regulator 310. In this embodiment, the signal processing circuit 330 comprises a resistor R5 and a current source I3, wherein the resistor R5 may be a combination or a series of multiple resistors. The signal processing circuit 330 can be regarded as a level shifting circuit or a voltage divider, that is the feedback signal VFB may be obtained by using a multiplexer to select one of multiple voltages respectively corresponding to multiple internal nodes of these multiple resistors.

In the embodiment shown in FIG. 3, by using the internal sensing signal Vs of the amplifier 320 to generate the feedback signal VFB, for the regulator 310 to adjust the voltage level of the regulated supply voltage VDD', the amplifier 320 can maintain good performance even in the presence of semiconductor process variation (or process corner variations).

## Claims

1. A circuitry (100, 200, 300), comprising:
a regulator (110, 210, 310), configured to receive a supply voltage to generate a regulated supply voltage according to a reference voltage and a feedback signal;
a load circuit (120, 220, 320) supplied by the regulated supply voltage, wherein the load circuit (120, 220, 320) comprises an internal sensing circuit to generate an internal sensing signal; and
a signal processing circuit (130, 230, 330), configured to process the internal sensing signal to generate the feedback signal to the regulator (110, 210, 310).

2. The circuitry (100, 200, 300) of claim 1, wherein the load circuit (120, 220, 320) is an amplifier, and the internal sensing circuit senses a voltage at an output terminal of the amplifier, as the internal sensing signal.

3. The circuitry (200, 300) of claim 1, wherein the load circuit (220, 320) is an amplifier configured to receive a differential input signal to generate a differential output signal, and the internal sensing circuit (Z1, Z2) senses a common-mode voltage of output terminals of the amplifier, as the internal sensing signal.

4. The circuitry (200, 300) of claim 3, wherein the internal sensing circuit (Z1, Z2) uses two impedance circuits to sense the common-mode voltage of output terminals of the amplifier, as the internal sensing signal.

5. The circuitry (200, 300) of claim 1, wherein the load circuit (220, 320) is an amplifier having a radio frequency (RF) choke (L1, L2), and the internal sensing circuit (Z1, Z2) senses a voltage at a terminal of the RF choke, as the internal sensing signal.

6. The circuitry (200, 300) of claim 1, wherein the load circuit (220, 320) is an amplifier, and the amplifier comprises:
an amplification circuit (M1, M2, M3, M4), configured to receive a differential input signal to generate a differential output signal at output terminals of the amplifier;
two RF chokes (L1, L2) coupled between the regulated supply voltage and the output terminals of the amplifier; and
the internal sensing circuit (Z1, Z2), configured to sense a common-mode voltage of the output terminals of the amplifier, as the internal sensing signal.

7. The circuitry (100, 200, 300) of any of claims 1-6, wherein the signal processing circuit (130, 230, 330) is a level shifting circuit.

8. The circuitry (100, 200, 300) of any of claims 1-7, wherein the regulator, the load circuit and the signal processing circuit are within a chip.
